# EUROPÄISCHE PATENTSCHRIFT

(11) **EP 4 025 841 B1**
(45) Veröffentlichungstag und Bekanntmachung des Hinweises auf die Patenterteilung: **06.11.2024**
(21) Anmeldenummer: 20768320.2
(22) Anmeldetag: 04.09.2020
(51) Int. Cl.: F24H 1/10, G01R 27/22, H02H 11/00, F24H 9/20, F24H 15/31, F24H 15/37, F24H 15/20

(54) **NIEDERHALTER ZUM NIEDERHALTEN EINES MESSSENSORS UND WEITERLEITEN EINES ELEKTRISCHEN MESSSIGNALS**
HOLD-DOWN DEVICE FOR HOLDING DOWN A MEASURING SENSOR AND FORWARDING AN ELECTRIC MEASUREMENT SIGNAL
DISPOSITIF DE RETENUE DESTINÉ À RETENIR UN CAPTEUR DE MESURE ET À TRANSMETTRE UN SIGNAL DE MESURE ÉLECTRIQUE

(30) Priorität: 05.09.2019 DE 102019123761
(43) Veröffentlichungstag der Anmeldung: 13.07.2022
(73) Patentinhaber: Stiebel Eltron GmbH & Co. KG, 37603 Holzminden (DE)
(72) Erfinder: ARNEMANN, Christian, 37671 Höxter (DE); HOLTDIRK, Moritz, 59556 Lippstadt (DE); ENGELKE, Stefan, 38302 Wolfenbüttel (DE)
(86) Internationale Anmeldenummer: PCT/EP2020/074796
(87) Internationale Veröffentlichungsnummer: WO 2021/044001

(56) Entgegenhaltungen:
- EP-A2- 1 690 971
- WO-A1-2004/048676
- DE-A1- 102014 000 536
- DE-A1- 2 803 951
- KR-A- 20040 087 177

## Beschreibung

Die Erfindung bezieht sich auf eine fluidführende Baugruppe für ein Haustechnikgerät, insbesondere Durchlauferhitzer, mit einem fluidführenden Bauteil mit einem sich durch das Bauteil erstreckenden fluidleitenden Bauteilleitungsabschnitt, der auf gegenüberliegenden Seiten jeweils einen Anschluss zur Verbindung mit jeweils einer fluidführenden Leitung aufweist; und einem in den Bauteilleitungsabschnitt zumindest teilweise hineinragenden Messsensor.

Fluidführende Haustechnikgeräte sind zum Beispiel Durchlauferhitzer, die zum Erzeugen von Warmwasser unter Verwendung insbesondere elektrischer Energie eingesetzt werden. Ein solcher Durchlauferhitzer umfasst ein oder mehrere elektrische Heizelemente, mit der Hilfe in Abhängigkeit der den Heizelementen zugeführten elektrischen Leistung ein durch Kanäle im Durchlauferhitzer geführtes Fluid, typischerweise Wasser, auf eine gewünschte, voreinstellbare Temperatur erhitzt werden kann. Durchlauferhitzer liefern Warmwasser ohne Standby-Verluste, weil sie Wasser nur dann erhitzen, wenn heißes Wasser benötigt wird. Obwohl das Vorstehende mit Bezug auf Durchlauferhitzer beschrieben wurde, so ist die erfindungsgemäße Lehre analog auf andere fluidführende Haustechnikgeräte übertragbar.

Moderne Durchlauferhitzer sind entweder mit einem Blankdraht-Heizelement oder mit einem mit Metall ummantelten Heizelement ausgestattet. Die Potentialdifferenz zwischen dem Blankdraht und den mit dem Erdpotential elektrisch leitend verbundenen Wasserzulaufkanal bzw. dem Wasserablaufkanal führt während des Betriebs der Heizeinrichtung zu entsprechenden Ableitströmen. Demnach sind Ableitstrecken vorgesehen, so dass insbesondere übermäßige elektrische Ableitströme an den mit dem Erdpotential verbundenen Wasserzulauf- und Wasserablaufanschlüssen verhindert werden. Die Größe dieser Ableitströme hängt dabei unter anderem auch von der Leitfähigkeit des durch die Kanäle fließenden Wassers ab. Des Weiteren besteht bei einem Blankdraht-Heizelementsystem die Gefahr der Überhitzung des Drahtelementes, wenn Luftblasen mit dem Wasser in das Gerät gelangen.

Um die Einhaltung eines vorgegebenen Ableitstromgrenzwertes zu überwachen und zu steuern, schlägt die EP 2 840 404 eine Steuereinrichtung vor, die eine zum Ermitteln eines hypothetischen Ableitstromwertes auf Basis des Leitfähigkeitswertes und mindestens einem, vorgegebenen, bauartbedingten Geräteparameter eingerichtete Auswerteeinheit umfasst und angepasst ist, die Heizleistung der Blankdrahtheizeinrichtung zu reduzieren, sofern der hypothetische Ableitstromwert einen vorgegebenen Ableitstromschwellwert übersteigt. Durch die Ermittlung des hypothetischen Ableitstromwertes sei es möglich, den tatsächlich gegen Erde fließenden Ableitstrom in Abhängigkeit des Leitfähigkeitswertes und des Geräteparameters exakt zu bestimmen und erst im Falle einer Überschreitung des vorgegebenen Ableitstromschwellwertes durch die Reduktion der Heizleistung der Blankdrahtheizeinrichtung den tatsächlich gegen Erde fließenden Ableitstrom zu reduzieren. Mit der Frage, wie ein Messsensor befestigt werden kann, beschäftigt sich das Dokument jedoch nicht.

DE 28 03 951 A1 betrifft einen Durchlauferhitzer mit zwei in einem wasserführenden Kanal angeordneten Elektroden, die auf Basis einer Gleichspannung den Widerstand des Wassers. Der Durchlauferhitzer umfasst ein Gehäuse mit drei Kammern, in denen Blankdrahtheizkörper angeordnet sind. Die Kammern sind über einen Kanal oben miteinander verbunden. Die Kammer mündet unten in einen Ringkanal, der oben in die Kammer führt. An die Kammer ist unten eine Wasservorlaufleitung angeschlossen. Aus der Kammer führt eine Wassernachlaufleitung. Die Wandungen der Vorlaufleitung, der Nachlaufleitung und der Kanäle sind aus einem elektrisch nichtleitendem Material. In das Gehäuse ist ein Elektrodenträger mit zwei Elektroden eingeschraubt.

DE 10 2014 000536 A1 betrifft eine Messeinrichtung zum Erfassen einer elektrischen Leitfähigkeit von Wasser in einem elektrischen Durchlauferhitzer mittels zweier Elektroden. Es wird gelehrt, dass als Elektroden können Elemente des Durchlauferhitzers verwendet werden können, die ohnehin vorhanden sind, wie zum Beispiel ein Einlaufrohr oder ein Auslaufrohr aus Kupfer, oder ein Temperaturfühlergehäuse oder eine Temperaturfühleraufnahme verwendet werden, die einen Temperaturfühler in dem Wasserkanal aufnimmt und selbst aus Metall gefertigt ist.

WO 2004/048676 A1 betrifft einen Leitfähigkeitssensor für Waschwasser, um eine Waschmaschine anhand der der Härte des Waschwassers, berechnet aus der gemessenen Leitfähigkeit des Waschwassers, zu steuern.

EP 1 690 971 A2 betrifft eine Heizeinrichtung für eine Waschmaschine oder eine Spülmaschine. In der Maschine ist die Heizeinrichtung in einer Wasserführung vorgesehen, wobei sie wenigstens ein Heizelement aufweist und mittels einer Halterung in einer Öffnung der Wandung der Wasserführung gelagert ist. An der Halterung ist auch eine Leitfähigkeitsmessvorrichtung angeordnet, die in die Wasserführung ragt.

Die der vorliegenden Erfindung zugrundeliegende Aufgabe besteht somit darin, eine fluidführende Baugruppe für ein Haustechnikgerät, insbesondere einen elektrischen Durchlauferhitzer zur Warmwasserbereitung, der vorbezeichneten Gattung anzugeben, die eine vorteilhafte, insbesondere einfache und kostengünstige, Befestigung des Messsensors an dem Haustechnikgerät und eine vorteilhafte, insbesondere einfache und kostengünstige, elektrische Verbindung des Messsensors mit einer Steuerungseinrichtung des Haustechnikgeräts ermöglicht.

Erfindungsgemäß wird diese Aufgabe dadurch gelöst, dass die fluidführende Baugruppe einen mit dem Messsensor elektrisch leitend verbundenen Niederhalter zum Weiterleiten eines elektrischen Messsignals zwischen dem Messsensor und der Steuerungseinrichtung des Haustechnikgeräts aufweist, wobei der Niederhalter einen Niederhalteabschnitt zum Niederhalten des Messsensors und Ausbilden einer elektrisch leitenden Verbindung mit dem Messsensor und einen mit dem Niederhalteabschnitt elektrisch leitend verbundenen Verbindungsabschnitt zum Schließen einer elektrischen Verbindung mit der Steuerungseinrichtung aufweist.

Hervorzuheben ist insbesondere der durch die erfindungsgemäße Baugruppe ermöglichte Vorteil, dass durch den Niederhalter eine Befestigung des Messsensors an der Baugruppe und gleichzeitig eine stabile elektrische Verbindung des Messsensors mit der Steuerungseinrichtung ermöglicht wird. Dadurch werden beide Erfordernisse in einfacher und kostengünstiger Weise erfüllt.

Das Haustechnikgerät ist oder beinhaltet insbesondere wenigstens ein Gerät, das aus der folgenden Liste ausgewählt ist: ein Durchlauferhitzer, ein Heißwassersystem, ein Trinkwasser-Wärmepumpe, ein Kleinspeicher, ein Wandspeicher, ein Standspeicher und/oder ein Kochendwassergerät.

Gemäß einer bevorzugten Ausgestaltung der Erfindung weist der Niederhalteabschnitt Öffnungen zum Durchtritt des als zwei beabstandete Elektroden ausgestalteten Messsensors auf. Dabei sind der Niederhalteabschnitt, insbesondere die Öffnungen, und die Mantelfläche der Elektroden derart zueinander angepasst, dass zwischen dem Niederhalter und dem Messsensor eine kraft-, form-, und/oder stoffschlüssige Verbindung besteht.

Vorzugsweise kann eine durch die Öffnung definierte ringförmige Öffnungsinnenkante in eine ringförmige Einkerbung, die in einem Bereich zwischen einem unteren Abschnitt und einem oberen Abschnitt der Elektroden angeordnet ist, rastend eingreifen und sich mit einer elastischen Federkraft gegen die Einkerbung abstützen. Die elastische Federkraft kann durch zwei sich von der Öffnungsinnenkante in entgegengesetzte Richtungen in den Niederhalter erstreckende Federschenkel realisiert werden. Alternativ oder zusätzlich kann ein oberer Elektrodenabschnitt mit einem Gewinde versehen werden, so dass ein im unteren Elektrodenabschnitt angeordneter Materialvorsprung (bspw. kann der Durchmesser bzw. Umfang wenigstens in einem Teil des unteren Elektrodenabschnitts größer sein als die im Niederhalteabschnitt befindliche Öffnung) gegen eine Unterseite des Niederhalters mittels einer Befestigungsmutter verspannt werden kann.

In einer weiteren vorteilhaften Ausgestaltung kann die Verbindung kraftschlüssig ausgeführt sein, wobei insbesondere zumindest ein federndes Bauteil vorgesehen ist. Der Niederhalter ist vorteilhaft selbst federnd, federnd gelagert oder weist zumindest eine Feder auf. Weiterhin kann vorteilhaft eine zusätzliche Feder am Niederhalter angebracht sein, die den Niederhalter federnd mit der Elektrode zumindest elektrisch kontaktiert und/oder verbindet und eine Kraft aufbringt. Gemäß einer weiteren, bevorzugten Ausgestaltung der Erfindung weist der Niederhalter einen Befestigungsabschnitt und/oder das fluidführende Bauteil Befestigungsmittel zur Befestigung, insbesondere zum Niederhalten, des Niederhalters an dem fluidführenden Bauteil. Eine Möglichkeit der Befestigung stellt ein durch eine im Befestigungsabschnitt angeordnete Öffnung greifendes am Bauteil fixierbares Befestigungsmittel wie bspw. eine Schraube dar, die mit einem im Bauteil vorgesehenen Gewinde als Befestigungsmittel verschraubbar ist. Damit kann nicht nur der Messsensor in der Messstrecke fixiert werden, sondern es wird auch ein Befestigungspunkt für das zur Steuerungseinrichtung führende elektrische Kabel bereitgestellt. Als weitere Möglichkeit der Befestigung ist der Niederhalter und das Bauteil ausgestaltet, dass der Niederhalter vom Messsensor teilweise in einen bauteilseitig vorgesehenen im Wesentlichen U-förmigen Materialvorsprung drängbar ist. Es sei jedoch bemerkt, dass die vorliegende Erfindung nicht auf bestimmte Ausführungsformen des Niederhaltens beschränkt ist, sondern insbesondere auch ein Verclipsungs-, Verrastungs- oder Bajonettverschluss zum Verriegeln des Messsensors eingesetzt werden kann.

Gemäß einerweiteren, bevorzugten Ausgestaltung der Erfindung ist der Niederhalter zweiteilig ausgebildet und jedes Niederhalteteil weist jeweils einen Niederhalteabschnitt zum Niederhalten und Kontaktieren jeweils einer Elektrode des als zwei beabstandete Elektroden ausgestalteten Messsensors und jeweils einen mit dem Niederhalteabschnitt elektrisch leitend verbundenen Verbindungsabschnitt zum Schließen jeweils einer elektrischen Verbindung mit der Steuerungseinrichtung auf. In dieser Ausgestaltung kann der Messsensor als eine Baugruppe verstanden werden, die zwei Elektroden aufweist. Diese Ausgestaltung zeichnet sich durch ihre Einfachheit und die Tatsache, dass keine besonders hohen Anforderungen an die Fertigungsgenauigkeit hinsichtlich der Niederhalteteile gestellt werden.

Die Konstruktion stellt einen definierten Abstand der zwei Elektroden in dem Bauteil des Haustechnikgerätes bereit. Wenn beispielsweise das Bauteil in Spritzgusstechnik hergestellt wird, ist die Position der Elektroden in dem Bauteil genau definiert, ohne dass die Niederhalteteile einer besonderen Genauigkeit zu unterliegen haben. Durch den definierten Abstand der Elektroden kann die Messungenauigkeit verringert werden, außerdem kann auf eine Kalibrierung eines Widerstandsschwellwertes, beispielsweise zur Leitwertmessung, verzichtet werden.

Gemäß einer bevorzugten Ausgestaltung sind die beiden Niederhalterteile identisch ausgeführt. Damit kann die Anzahl der Komponenten und die Komplexität der Fertigung gering gehalten werden. Besonders bevorzugt werden die beiden Niederhalterteile dann spiegelverkehrt auf dem fluidführenden Bauteil montiert. Hierbei können entsprechend auf dem fluidführenden Bauteil vorgesehene Führungen eine Falschmontage vermeiden.

Gemäß einer alternativen Ausgestaltung der Erfindung ist der Niederhalter einteilig ausgebildet und weist zwei Niederhalteabschnitte mit jeweils einem Niederhalteabschnitt zum Niederhalten und Kontaktieren jeweils einer Elektrode des als zwei beabstandete Elektroden ausgestalteten Messsensors und jeweils einem mit dem Niederhalteabschnitt elektrisch leitend verbundenen Verbindungsabschnitt zum Schließen jeweils einer elektrischen Verbindung mit der Steuerungseinrichtung auf. Vorzugsweise weist der Niederhalter in dieser Ausgestaltung eine Leiterplatte auf bzw. besteht daraus, so dass insbesondere durch die nichtleitende Leiterplatte die zwei voneinander elektrisch getrennten Niederhalteabschnitte umgesetzt werden können. Diese Ausgestaltung zeichnet sich durch ihre Einfachheit und der Tatsache, dass lediglich ein Bauteil zum Niederhalten und Kontaktieren zweier Elektroden notwendig ist, aus. Des Weiteren kann die elektrische Verbindung mit der Steuerungseinrichtung über nur einen (zweipoligen) Stecker geschlossen werden.

Gemäß einerweiteren, bevorzugten Ausgestaltung der Erfindung ist das Bauteil aus einem nichtleitenden Material gefertigt. Dadurch kann auf eine elektrische Isolierung der elektrisch leitenden Bereiche des Niederhalters gegen das Bauteil verzichtet werden. Das Bauteil ist beispielsweise ein Flansch des Haustechnikgeräts, in das der erfindungsgemäße Niederhalter und optional andere Bauteile, beispielsweise zur Leitwertmessung, eingeschraubt bzw. daran befestigt werden.

Gemäß einer weiteren, bevorzugten Ausgestaltung der Erfindung ist das Bauteil als Flansch ausgebildet, der auf einer Seite einen Anschluss an eine Rohrleitung und auf einer gegenüberliegenden Seite einen Anschluss an einen Heizleitungsabschnitt aufweist. Vorzugsweise handelt es sich bei der Rohrleitung um eine warmwasserableitende Rohrleitung. Das bedeutet, der Messsensor ist in einer Nachschaltstrecke angeordnet, wodurch der Messsensordas Messsignal in einem Abschnitt, in dem die kritischste (größte) Leitfähigkeit zu erwarten ist, erfassbar ist. Auch andere Flanschvarianten, beispielsweise mit einem Anschluss an eine Kaltwasserleitung oder Flansche, die beidseitig Heizleitungsabschnitte umfassen, sind möglich.

Gemäß einer weiteren, bevorzugten Ausgestaltung der Erfindung ist der Verbindungsabschnitt als längliches Flachstück ausgebildet. Das längliche Flachstück ist beispielsweise zur Verbindung mit einer Flachsteckerhülse oder einem Raststeckverbinder ausgeformt. Dadurch ergibt sich eine Steckverbindung, die im Falle einer Reparatur, Wartung, o. Ä. einfach gelöst werden kann.

Gemäß einer weiteren, bevorzugten Ausgestaltung der Erfindung ist der Verbindungsabschnitt als Litzenanschluss ausgebildet. Demnach kann eine Litze direkt an den Verbindungsabschnitt angecrimpt werden, ohne dass eine Steckerhülse oder ähnliches vorzusehen ist.

Besonders bevorzugt ist der Messsensor als zwei voneinander beabstandete Elektroden ausgebildet. Vorzugsweise sind die Elektroden als zwei quer zum Strömungskanal des Bauteilleitungsabschnittes beabstandete Elektroden ausgebildet. Durch die Anordnung insbesondere quer, das heißt optional mit einer Längskomponente in Richtung des Strömungskanals, oder orthogonal, das heißt rechtwinklig zum Strömungskanal, treten geringere Druckverluste im Strömungskanal auf. Dies ist strömungsrelevant, insbesondere hinsichtlich laminarer bzw. turbulenter Strömung, besonders bei kleinen Kanalquerschnitten.

Grundsätzlich können die Elektroden aus allen elektrisch leitenden und wasserführenden Komponenten gebildet werden. Besonders bevorzugt sind die Elektroden in einem Bereich von Durchlauferhitzern trinkwasserkonform. Diese können insbesondere ausgewählt sein aus der Gruppe bestehend aus Heizbolzen, Temperaturfühler, Messsonden, Ein- und/oder Auslaufrohr, Kühlrohr, Verschlussklammern, Verrasterungsklammern, Drucksensoren, Motorventilachsen, Schrauben und Drosselschrauben. Grundsätzlich ist es möglich, dass wenigstens eine Elektrode durch das Heizelement gebildet wird. Bevorzugt ist jedoch das Heizelement nicht Teil des Messsensors ist und zusätzlich zum Heizelement sind zwei Elektroden zur Erfassung des Widerstandwerts vorgesehen. Bezüglich der trinkwasserkonformen Materialien sei insbesondere Edelstahl aufgrund dessen einfachen Beschaffung, Korrosionsbeständigkeit, Resistenz gegen Fouling bzw. Kalkablagerungen und organische Effekte erwähnt. Des Weiteren sind metallbeschichtete, eloxierte, verchromte und vernickelte Materialien wie Metalle, Kunststoffe, Nichteisenmetalle und Sinterwerkstoffe denkbar.

Des Weiteren ist bevorzugt, dass die Messeinrichtung mit geringem Wechselstrom wie vorzugsweise Sicherheitskleinspannung betrieben wird. Dadurch werden unerwünschte Elektrolyseeffekte an der Messeinrichtung, insbesondere an den Elektroden, verringert. Um störende Polarisationseffekte an der Messeinrichtung, insbesondere an den Elektroden, zu minimieren ist ferner bevorzugt, dass die Messeinrichtung im Niederspannungsbereich betrieben wird.

Gemäß einer weiteren Ausgestaltung der Erfindung verläuft eine durch die Elektroden gebildete Messstrecke quer zu Strömungsrichtung. Die durch die Elektroden gebildete Messstrecke stellt die kürzeste Verbindung innerhalb der fluidführenden Leitung zwischen den Elektroden dar. Bevorzugt verläuft die Messtrecke quer, insbesondere, orthogonal zur Strömungsrichtung. Dadurch können Störströme verhindert werden und eine Beeinflussung der Strömung sowie Druckverluste minimiert werden.

Die der Erfindung zugrundeliegende Aufgabe wird außerdem gelöst durch ein Haustechnikgerät, insbesondere Durchlauferhitzer Heißwassersystem, Trinkwasser-Wärmepumpe, Kleinspeicher, Wandspeicher, Standspeicher und/oder Kochendwassergerät, mit einer fluidführenden Leitung; einem sich über einen Heizleitungsabschnitt erstreckenden Heizelement zum Erwärmen des durch die Leitung strömenden Fluids; einer Steuerungseinrichtung zur Steuerung einer Heizleistung des Heizelements zum Erwärmen des durch die Leitung strömenden Fluids; und einer mit der fluidführenden Leitung verbundenen fluidführenden Baugruppe wie hier beschrieben.

Gemäß einer bevorzugten Ausgestaltung der Erfindung ist der Messsensor ausgestaltet, um ein für die Leitfähigkeit des durch die fluidführende Leitung strömenden Fluids charakteristisches Messsignal abzugreifen, und die Steuerungseinrichtung ist vorzugsweise eingerichtet, um auf Basis der Leitfähigkeit die Heizleistung zu steuern.

Zum Schutz der Hauptelektronik vor Störeffekten (bspw. EMV, Burst, Surge-Effekten), weist die Steuerungseinrichtung vorzugsweise einen zur Ermittlung des Messsignals ausgebildeten Messschaltkreis und einen zur Steuerung der Heizleistung ausgebildeten Heizschaltkreis auf, und der Messschaltkreis ist vom Heizschaltkreis galvanisch getrennt.

Zur Vermeidung von Wiederholungen wird im Zusammenhang mit dem erfindungsgemä-βen Haustechnikgerät auf die zuvor gemachten Ausführungen zur Baugruppe verwiesen, die jeweils auch entsprechende Ausführungsformen des erfindungsgemäßen Haustechnikgeräts darstellen.

Die der Erfindung zugrundeliegende Aufgabe wird außerdem gelöst durch eine Verwendung eines elektrisch leitenden Niederhalters zum Niederhalten eines Messsensors und Weiterleiten eines elektrischen Messsignals zwischen dem in eine fluidführenden Leitung eines Haustechnikgeräts, insbesondere eines Durchlauferhitzers, eines Heißwassersystems, einer Trinkwasser-Wärmepumpe, eines Kleinspeichers, eines Wandspeichers, eines Standspeichers und/oder eines Kochendwassergeräts, zumindest teilweise hineinragenden Messsensor und einer Steuerungseinrichtung des Haustechnikgeräts, wobei der Niederhalter einen Niederhalteabschnitt zum Niederhalten des Messsensors und Ausbilden einer elektrisch leitenden Verbindung mit dem Messsensors und einen mit dem Niederhalteabschnitt elektrisch leitend verbundenen Verbindungsabschnitt zum Schließen einer elektrischen Verbindung mit der Steuerungseinrichtung aufweist.

Vorzugsweise ist der Niederhalter und/oder das Haustechnikgerät, insbesondere Durchlauferhitzer, wie hier näher beschrieben ausgestaltet. Zur Vermeidung von Wiederholungen wird im Zusammenhang mit der erfindungsgemäßen Verwendung auf die zuvor gemachten Ausführungen zur Baugruppe und zum Haustechnikgerät verwiesen, die jeweils auch entsprechende Ausführungsformen der erfindungsgemäßen Verwendung darstellen.

Weitere bevorzugte und/oder zweckmäßige Merkmale und Ausgestaltungen der Erfindung ergeben sich aus den Unteransprüchen und der Beschreibung. Nachfolgend wird die Erfindung anhand von Ausführungsbeispielen unter Bezugnahme auf die beigefügten Figuren näher beschrieben. Ähnliche oder gleiche Bauteile sind mit denselben Bezugszeichen bezeichnet.

Hierbei zeigen:
- Fig. 1: eine schematische Ansicht einer bevorzugten Ausführungsform eines erfindungsgemäßen Haustechnikgerätes;
- Fig. 2: eine perspektivische Ansicht eines warmwasserauslassseitigen Flansches einer bevorzugten Ausführungsform eines erfindungsgemäßen Haustechnikgeräts;
- Fig. 3: den in Fig. 2 dargestellten warmwasserauslassseitigen Flansch in Draufsicht;
- Fig. 4: eine Ansicht des warmwasserauslassseitigen Flansches im Schnitt entlang der in Fig. 3 dargestellten Ebene A-A;
- Fig. 5: eine perspektivische Ansicht des in den Fig. 2 bis 4 dargestellten Niederhalters alleine und in Kombination mit weiteren Bauteilen einer bevorzugten Ausführungsform des erfindungsgemäßen Haustechnikgerätes;
- Fig. 6: Teilansichten weiterer Ausführungsformen eines erfindungsgemäßen Haustechnikgerätes im Schnitt und von oben; und
- Fig. 7: Teilansichten weiterer Ausführungsformen der Niederhalterteile.

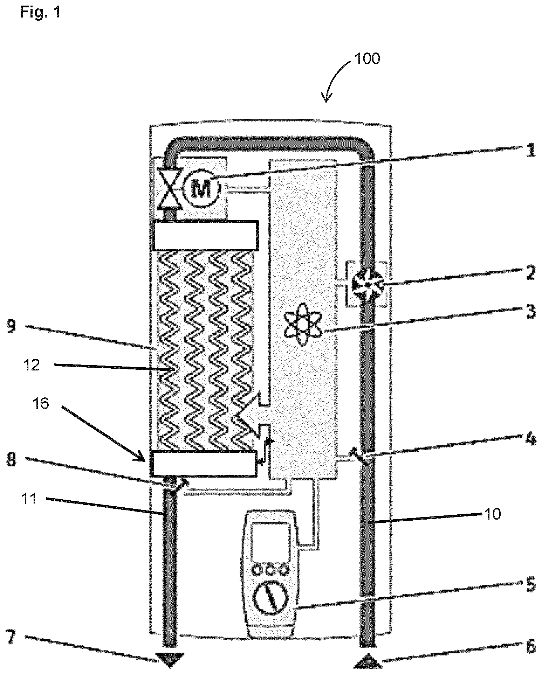

Fig. 1 zeigt ein Haustechnikgerät 100, insbesondere einen elektrischen Durchlauferhitzer, mit einer fluidführenden Leitung 9, 10, 11, in dem sich in einem Leitungsabschnitt 9 ein Heizelement 12 zum Erwärmen des durch die Leitung 9, 10, 11 strömenden Fluids erstreckt. Heizelement 12 kann als Blankdrahtheizelement oder Rohrheizelement, vorzugsweise Blankdrahtheizelement, ausgebildet sein. Das Haustechnikgerät umfasst ferner einen Kaltwasserreinlass 6 zum Anschluss an eine wasserzuführende Wasserleitung und einen Warmwasserauslass 7. Der Warmwasseranschluss 7 kann über eine nicht dargestellte Warmwasserleitung mit einem Wasserhahn verbunden sein. Insbesondere wenn es sich bei Heizelement 12 um ein Blankdrahtelement handelt, weist die Leitung vor und hinter dem Heizelement 12 eine Vorschaltstrecke 10 und Nachschaltstrecke 11 auf. Dabei handelt es sich um unbeheizte Kanäle, die als Widerstandsstrecken für die am stromdurchflossenen Heizelement 12 anstehenden hohen Spannungen dienen, so dass an den Anschlüssen kein hoher Ableitstrom fließt. Bei einem bestimmungsgemäßen Anschluss der Anschlüsse 6, 7 an einen Schutzleiter fließt der Ableitstrom über den Schutzleiter ab.

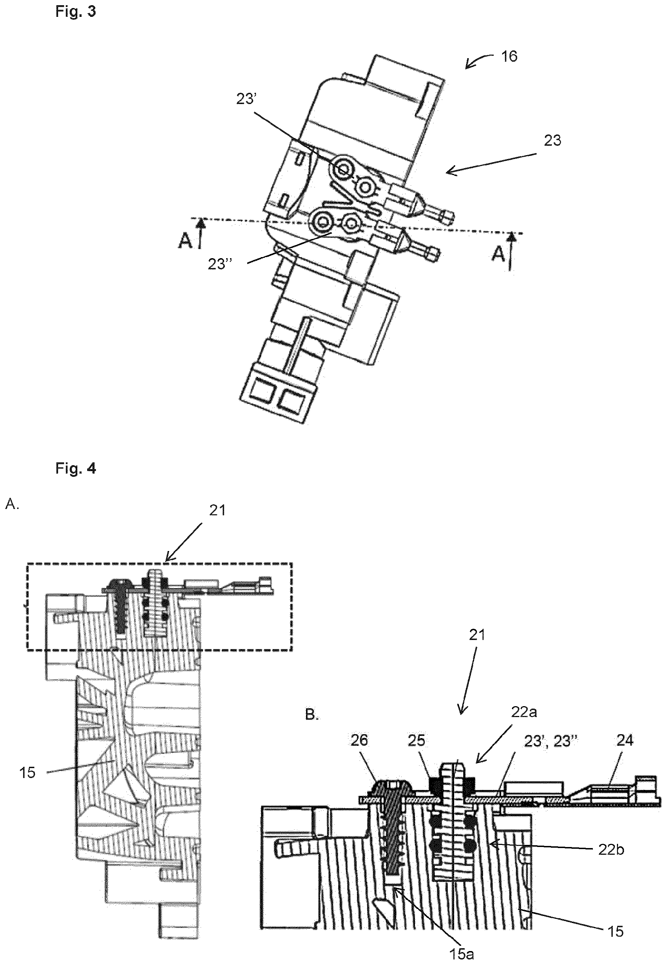

Das Haustechnikgerät 100 weist erfindungsgemäß eine fluidführende Baugruppe 16 auf, die in der vorliegenden Darstellung als warmwasserauslassseitiger Flansch ausgebildet ist. Die Baugruppe 16 weist einen Messsensor 21 auf (am besten in Fig. 4 zu erkennen), der mit einer elektronische Steuerungseinrichtung 3 leitend verbunden ist.

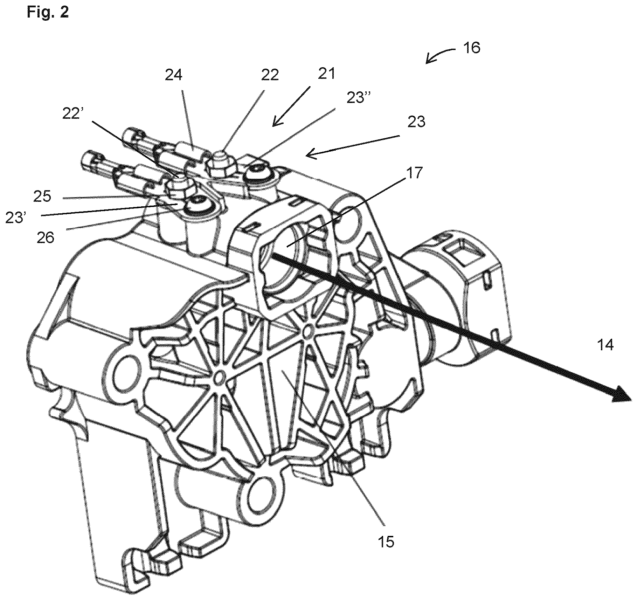

Der Messsensor 21 weist in dieser Ausführung zwei Elektroden 22, 22' auf. Der Messsensor 21, bzw. die Elektroden 22, 22', ragen, vgl. Fig. 2, zumindest teilweise in einen Bauteilleitungsabschnitt 17 hinein.

Der Messsensor 21 ist vorzugsweise zum Erfassen eines Werts einer von der Leitfähigkeit des Fluids abhängigen Kenngröße, insbesondere eines elektrischen Widerstands- oder Leitfähigkeitswertes, ausgestaltet. Die Steuerungseinrichtung 3 ist zum Steuern einer Heizleistung des Heizelements 12 zum Erwärmen des durch die Leitung strömenden Fluids eingerichtet.

Das Haustechnikgerät 100 kann ferner einen, mehrere oder folgende in Fig. 1 dargestellte Komponenten optional aufweisen.
- Einlasstemperatursensor 4 und/oder Auslasstemperatursensor 8, der in einem zu dem Heizelement 12 zuführenden Leitungsabschnitt 10 (Vorschaltstrecke) bzw. in einem von dem Heizelement 12 abführenden Leitungsabschnitt 11 (Nachschaltstrecke) angeordnet sein kann; und/oder
- Durchflusssensor 2, der in der Leitung 9, 10, 11, bspw. in der Vorschaltstrecke 10, angeordnet sein kann; und/oder
- Ventil 1 (in Fig. 1 als motorbetriebenes Ventil dargestellt), das in der Vorschaltstrecke 10 angeordnet sein kann; und/oder
- Bedienteil 5 zum Bedienen und/oder Warten des Haustechnikgeräts 100.

Vorzugsweise sind die vorgenannten Bestandteile (sofern vorhanden) mit der Steuerungseinrichtung 3 funktional gekoppelt, so dass die Steuerungseinrichtung 3 die Heizleistung von dem Heizelement 12 und/oder Ventilstellung von dem Ventil 1 in Abhängigkeit vom Durchfluss und/oder Eingangs- und/oder Ausgangstemperatur des Fluids und/oder einer gewünschten (vorbestimmten) Warmwassertemperatur steuert.

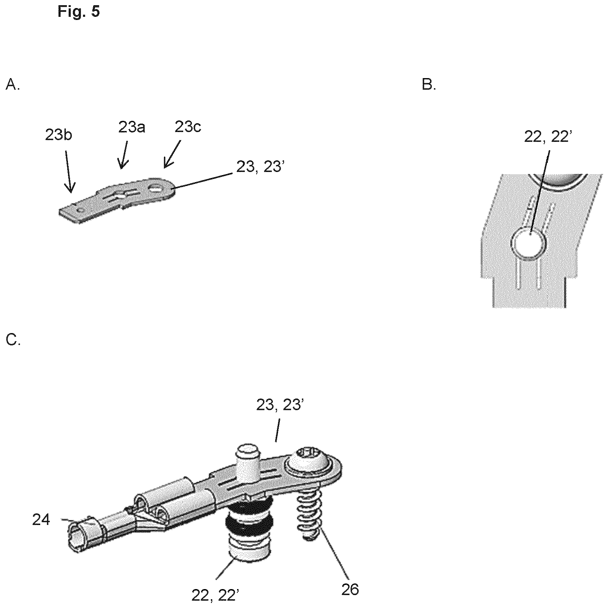

Fig. 2 zeigt die Baugruppe 16 mit einem als warmwasserauslassseitigen Flansch ausgebildeten Bauteil 15, ein Niederhalter 23 und als einen Elektroden 22, 22' ausgebildeten Messsensor 21. Der Niederhalter 23 ist zweiteilig ausgebildet und weist zwei Niederhalteteile 23', 23" auf, die an der Gehäuseoberseite des Bauteils 15 befestigt sind. Die Befestigung der Niederhalteteile 23', 23" ist im dargestellten Beispiel mit jeweils einer durch einen in Fig. 5 näher dargestellten Befestigungsabschnitt 23c der Niederhalteteile 23', 23" durchgreifendes Befestigungselement 26 (hier: Schraube) bewerkstelligt. Die Besonderheit des Aufbaus zeigt sich durch die Kombination aus dem Niederhalten von Messelektroden und deren elektrischer Kontaktierung zur Übertragung von Messsignalen.

Fig. 3 zeigt die Baugruppe 16 von oben. Eine Schnittansicht durch Ebene A-A ist in Fig. 4 dargestellt. In der in Fig. 4A dargestellten Schnittansicht und insbesondere der in Fig. 4B gezeigten vergrößerten Teildarstellung ist zu erkennen, dass das Bauteil 15 eine sich von der Oberfläche erstreckende zylinderförmige Materialaussparung zur Aufnahme eines unteren Elektrodenabschnitts 22b und ein sich von derselben Oberfläche erstreckendes Gewinde zur Befestigung des Niederhalters 23, 23' mittels eines Befestigungselements 26 aufweist. Des Weiteren weisen Elektroden 22, 22' in einem oberen Elektrodenabschnitt 22a ein Gewinde zur Verspannung des einen Materialvorsprung aufweisenden unteren Elektrodenabschnitts 22b gegen die Unterseite des Niederhalteteils 23', 23" mittels einer Sicherungsmutter 25 auf. Die Elektroden 22, 22', die auch als Messbolzen bezeichnet werden können, erstrecken sich durch das Bauteil 15 in das Innere des Bauteilleitungsabschnitts 17, so dass sie in Kontakt mit durch die Leitung 9 strömendem Fluid stehen. Zur Abdichtung ist der untere Elektrodenabschnitt 22b beispielsweise mit umlaufenden Dichtungen (hier zwei O-Ringe) versehen. In diesem Ausführungsbeispiel ragen die Messbolzen beispielhaft in die den Warmwasserkanal bildende Leitung 9, während in anderen Ausführungen auch die Leitungen 10, 11 auf gleiche Weise verwendet werden können.

Eine Detaildarstellung eines Niederhalteteils 23', 23" mit mittig angeordnetem Niederhalteabschnitt 23a und auf gegenüberliegenden Seiten des Niederhalteabschnitt 23a angeordnetem Verbindungsabschnitt 23b und Befestigungsabschnitt 23c zum Befestigen von dem Niederhalteteil 23', 23" mittels dem Befestigungselements 26 ist in Fig. 5 zu sehen. In dieser Ausführung greift eine durch die Öffnung definierte ringförmige Öffnungsinnenkante in eine in einem Bereich zwischen einem unteren Abschnitt 22b und einem oberen Abschnitt 22a der Elektroden 22, 22' angeordnete ringförmige Einkerbung rastend ein und stützt sich mit der elastischen Federkraft zweier von der Öffnungsinnenkante sich in den Niederhalter erstreckender Federschenkel gegen die Einkerbung ab. Dadurch wird eine kraft-, form- und/oder stoffschlüssige Verbindung zwischen dem Niederhalteteil 23', 23" und der jeweiligen Elektrode 22, 22' erreicht. Es kann auf eine zusätzliche Sicherungsmutter zum Verspannen von den Elektroden 22,22' gegen die Unterseite von dem Niederhalteteil 23', 23" verzichtet werden. Zum Schließen einer elektrischen Verbindung mit der Steuerungseinrichtung 3 ist jeweils der Verbindungsabschnitt 23b der Niederhalteteile 23', 23" als längliches Flachstück zur Steckverbindung mit der Flachsteckhülse 24 ausgebildet. Dabei erstreckt sich vorzugsweise der Verbindungsabschnitt 24b entgegen der Flussrichtung 14 des Warmwasserauslaufs (vgl. Fig. 2), um einerseits ein angeschlossenes elektrisches Kabel von wärmeleitenden Metallrohrleitungen fern zu halten und andererseits das Kabel auf kurzem Weg zur Steuerungseinrichtung 3 zu führen.

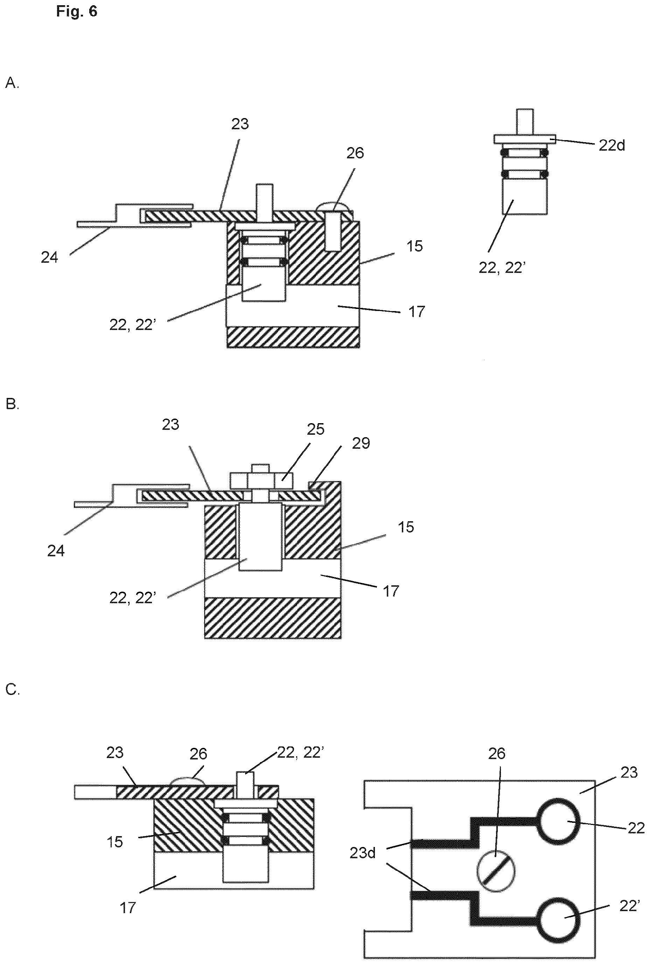

Fig. 6 zeigt Teilansichten weiterer Ausführungsformen einer erfindungsgemäßen Baugruppe 16 im Schnitt und von oben.

In Fig. 6A ist die Befestigung von dem Niederhalter 23 an dem Bauteil 15 durch ein als in das Bauteil 15 formschlüssig eingreifender Befestigungsbolzen ausgebildetes Befestigungselement 26 bewerkstelligt. Der Messsensor 21 ist als zwei bolzenförmige Elektroden 22, 22' ausgebildet, die mit einem Ende in den Bauteilleitungsabschnitt 17 hineinragen. Die Elektroden 22, 22' weisen in einem Bereich zwischen dem oberen Elektrodenabschnitt und dem unteren Elektrodenabschnitt einen ringförmigen Kragen 22d auf, der zusammen mit dem Niederhalter 23 eine Bewegung der Elektroden 22, 22' in axialer Richtung der Elektroden verhindert. Die Flachsteckhülse 24 kann zum Schließen einer elektrischen Verbindung mit der Steuerungseinrichtung 3 über den in Fig. 6B nicht näher bezeichneten Verbindungsabschnitt 23b gesteckt werden.

In Fig. 6B ist die Befestigung von dem Niederhalter 23 an dem Bauteil 15 dadurch bewerkstelligt, dass der Niederhalter 23 von der Elektrode 22, 22'in einen bauteilseitig vorgesehenen im Wesentlichen U-förmigen Materialvorsprung 29 gedrängt wird. Dabei ist die Elektrode 22, 22' als Messbolzen ausgeführt, der mit einem Ende in den Bauteilleitungsabschnitt 17 hineinragt. Die Elektroden 22, 22' weisen einen oberen Elektrodenabschnitt und einen gegenüber dem oberen Elektrodenabschnitt verbreiterten unteren Elektrodenabschnitt auf, der mittels der Sicherungsmutter 25 gegen die Unterseite von dem Niederhalteteil 23', 23" verspannbar ist, so dass eine Bewegung der Elektroden 22, 22' in axialer Richtung der Elektroden verhindert wird. Die Flachsteckhülse 24 kann zum Schließen einer elektrischen Verbindung mit der Steuerungseinrichtung 3 über den in Fig. 6B nicht näher bezeichneten Verbindungsabschnitt 23b gesteckt werden. Es sollte beachtet werden, dass auch andere Befestigungsmöglichkeiten vorstellbar sind, beispielsweise ist auch eine Verbindung ohne Verschraubung wie in Fig. 6A denkbar.

In der in Fig. 6C gezeigten Variante sind Leiterbahnen 23d zur Kontaktierung von in den Bauteilleitungsabschnitt 17 hineinragenden Elektroden 22, 22' auf einem einteilig (als Platine) ausgebildeten Niederhalter 23 aufgebracht. Die elektrische Kontaktierung zwischen Niederhalter 23 und Elektroden 22, 22' ist vorzugsweise kraft-, form- und/oder stoffschlüssig. Der Niederhalter 23 kann an dem Bauteil 15 mittels Befestigungselement 26 verschraubt, verclipst oder verrastet werden. An dem als Platine ausgebildeten Niederhalter 23 kann ein Raststecker zur Verbindung mit der Steuerungseinrichtung 3 angeschlossen werden (in Fig. 6C nicht dargestellt).

Die Elektroden 22, 22' können in einer Ausführung als Inlay ausgestaltet werden und so eine formschlüssige und/oder kraftschlüssige Verbindung zwischen den Elektroden 22, 22' und dem Bauteil 15 ausbilden. Vorzugsweise können die Elektroden 22, 22' dann aus dem Fluidkanal 17 in Richtung der Außenseite eingeführt werden und bereits durch den Wasserdruck abdichten, so dass auf zusätzliche Dichtmittel verzichtet werden kann.

In einer weiteren Ausführung kann eine Verbindung, insbesondere eine stoffschlüssige Verbindung mittels Schweißen bzw. Löten zwischen Niederhalter 23 und Elektroden 22, 22' geschaffen werden, bevor der Niederhalter 23 bzw. die Baugruppe aus Niederhalter 23 und Elektroden 22, 22' mit dem fluidführenden Bauteil 15 verbunden wird. In dem Fall, in dem der Niederhalter 23 nichtmetallisch ist, insbesondere in Form einer Leiterplatte ausgebildet ist, sind dann vorzugsweise Schlitze zum Toleranzausgleich in der Platine vorzusehen. In einer Ausführung sind die Elektroden 22, 22' aus Edelstahl, wobei auch höherwertige Legierungen möglich sind. Grundvoraussetzung ist, dass die Elektroden 22, 22' elektrisch leitfähig und, aufgrund des Wasserkontaktes, korrosionsbeständig sind.

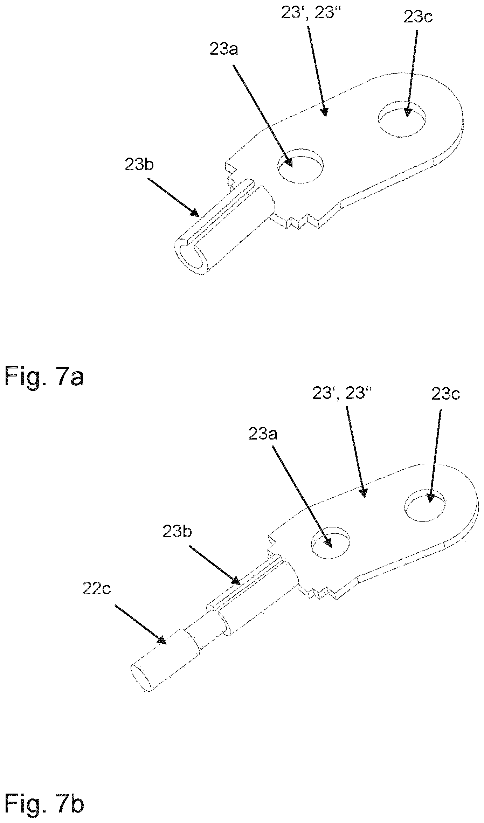

Fig. 7A und B zeigt weitere Teilansichten weiterer Ausführungsformen der Niederhalterteile 23', 23", die ebenso auch auf andere Ausgestaltungen des Niederhalters anwendbar ist. Im Unterschied zu der in Fig. 5 bzw. Fig. 6 gezeigten Ausführung weisen die Niederhalterteile 23', 23" in dem Verbindungsabschnitt 23b einen Litzenanschluss zum Anschluss einer Litze. Die Litze eines Leitungsdrahtes 22c kann beispielsweise durch Crimpen mit dem Verbindungsabschnitt 23b verbunden werden. Der Verbindungsabschnitt 23b macht damit die Verwendung beispielsweise einer Flachsteckhülse überflüssig.

### Bezugszeichenliste:

- 1: Motorisiertes Ventil
- 2: Durchflusssensor
- 3: Steuerungseinrichtung
- 4: Einlasstemperatursensor
- 5: Bedienteil
- 6: Kaltwassereinlass
- 7: Warmwasserauslass
- 8: Auslasstemperatursensor
- 9, 10, 11: Fluidführende Leitung
- 12: Heizelement
- 14: Flussrichtung Warmwasserauslauf
- 15: Bauteil
- 17: Bauteilleitungsabschnitt
- 16: Baugruppe
- 21: Messsensor
- 22, 22`: Elektroden
- 22a: Oberer Elektrodenabschnitt
- 22b: Unterer Elektrodenabschnitt
- 22c: Leitungsdraht
- 22d: Kragen
- 23: Niederhalter
- 23', 23": Niederhalteteil
- 23a: Niederhalteabschnitt
- 23b: Verbindungsabschnitt
- 23c: Befestigungsabschnitt
- 23d: Leiterbahn
- 24: Flachsteckhülse
- 25: Sicherungsmutter
- 26: Befestigungselement
- 29: Materialvorsprung
- 100: Haustechnikgerät

## Patentansprüche

1. Fluidführende Baugruppe (16) für ein Haustechnikgerät (100), insbesondere Durchlauferhitzer, Heißwassersystem, Trinkwasser-Wärmepumpe, Kleinspeicher, Wandspeicher, Standspeicher und/oder Kochendwassergerät, mit
- einem fluidführenden Bauteil (15) mit einem sich durch das Bauteil (15) erstreckenden fluidleitenden Bauteilleitungsabschnitt (17), der zwei insbesondere auf gegenüberliegenden Seiten angeordnete Anschlüsse zur Verbindung mit jeweils einer fluidführenden Leitung (9, 10, 11) aufweist;
- einem in den Bauteilleitungsabschnitt (17) zumindest teilweise hineinragenden Messsensor (21);
- einem mit dem Messsensor (21) elektrisch leitend verbundenen Niederhalter (23) zum Weiterleiten eines elektrischen Messsignals zwischen dem Messsensor (21) und einer Steuerungseinrichtung (3) des Haustechnikgeräts (100),
**dadurch gekennzeichnet, dass** der Niederhalter (23) einen ersten Niederhalteabschnitt (23a) zum Niederhalten des Messsensors (21) und Ausbilden einer elektrisch leitenden Verbindung mit dem Messsensor (21) und einen mit dem Niederhalteabschnitt (23a) elektrisch leitend verbundenen ersten Verbindungsabschnitt (23b) zum Schließen einer elektrischen Verbindung mit der Steuerungseinrichtung (3) aufweist.

2. Fluidführende Baugruppe (16) nach Anspruch 1, wobei der Messsensor (21) als eine erste Elektrode (22) und eine zweite von der ersten Elektrode (22) beabstandete Elektrode (22') ausgestaltet ist, und wobei optional der erste Niederhalteabschnitt (23a) Öffnungen zum Durchtritt der zwei Elektroden (22, 22') aufweist.

3. Fluidführende Baugruppe (16) nach Anspruch 1 oder 2, wobei der erste Niederhalteabschnitt (23a), insbesondere die Öffnungen, und eine Mantelfläche der Elektroden (22, 22') derart zueinander angepasst sind, dass zwischen dem Niederhalter (23) und dem Messsensor (21) eine kraft-, form-, und/oder stoffschlüssige Verbindung besteht.

4. Fluidführende Baugruppe (16) nach einem der vorhergehenden Ansprüche, wobei der Niederhalter (23) einen Befestigungsabschnitt (23c) und/oder das fluidführende Bauteil (15) Befestigungsmittel zur Befestigung des Niederhalters (23) an dem fluidführenden Bauteil (15) aufweist.

5. Fluidführende Baugruppe (16) nach einem der vorhergehenden Ansprüche 2 bis 4, wobei der Niederhalter (23) zweiteilig ausgebildet ist und das erste Niederhalteteil (23') den ersten Niederhalteabschnitt (23a) und das zweite Niederhalteteil (23") einen zweiten Niederhalteabschnitt (23a) aufweist, wobei der erste Niederhalteabschnitt (23a) zum Niederhalten und Ausbilden einer elektrisch leitenden Verbindung mit der ersten Elektrode (22') ausgestaltet ist und wobei der zweite Niederhalteabschnitt (23a) zum Niederhalten und Ausbilden einer elektrisch leitenden Verbindung mit der zweiten Elektrode (22) ausgestaltet ist und einen mit dem zweiten Niederhalteabschnitt (23a) elektrisch leitend verbundenen zweiten Verbindungsabschnitt (23b) zum Schließen jeweils einer elektrischen Verbindung mit der Steuerungseinrichtung (3) aufweist.

6. Fluidführende Baugruppe (16) nach Anspruch 5, wobei die beiden Niederhalteteile (23', 23") identisch ausgeführt sind und insbesondere spiegelverkehrt montiert werden.

7. Fluidführende Baugruppe (16) nach einem der vorhergehenden Ansprüche 1 bis 4, wobei der Niederhalter (23) einteilig ausgebildet ist und einen zweiten Niederhalteabschnitt aufweist, wobei der erste Niederhalteabschnitt (23a) zum Niederhalten und Ausbilden einer elektrisch leitenden Verbindung mit der ersten Elektrode (22) ausgestaltet ist und wobei der zweite Niederhalteabschnitt (23a) zum Niederhalten und Ausbilden einer elektrisch leitenden Verbindung mit der zweiten Elektrode (22) ausgestaltet ist und einen mit dem zweiten Niederhalteabschnitt (23a) elektrisch leitend verbundenen zweiten Verbindungsabschnitt (23b) zum Schließen jeweils einer elektrischen Verbindung mit der Steuerungseinrichtung (3) aufweist.

8. Fluidführende Baugruppe (16) nach einem der vorhergehenden Ansprüche, wobei das Bauteil (15) aus einem nichtleitenden Material gefertigt ist.

9. Fluidführende Baugruppe (16) nach einem der vorhergehenden Ansprüche, wobei das Bauteil (15) als Flansch (15) ausgebildet ist, der auf einer Seite einen Anschluss an eine Rohrleitung (10, 11), insbesondere eine Kaltwasserrohrleitung und/oder eine warmwasserableitende Rohrleitung, und auf einer gegenüberliegenden Seite einen Anschluss an einen Heizleitungsabschnitt (9) aufweist.

10. Fluidführende Baugruppe (16) nach einem der vorhergehenden Ansprüche, wobei der erste und/oder der zweite Verbindungsabschnitt (23b) als längliches Flachstück, vorzugsweise zur Verbindung mit einer Flachsteckerhülse (24) oder einem Raststeckverbinder, ausgeformt ist.

11. Fluidführende Baugruppe (16) nach einem der Ansprüche 1 bis 9, wobei der erste und/oder zweite Verbindungsabschnitt (23b) als Litzenanschluss ausgebildet ist.

12. Fluidführende Baugruppe (16) nach einem der vorhergehenden Ansprüche 2 bis 11, wobei die zwei Elektroden (22, 22') quer zum Strömungskanal des Bauteilleitungsabschnitts (17) ausgebildet sind.

13. Haustechnikgerät (100), insbesondere Durchlauferhitzer, Heißwassersystem, Trinkwasser-Wärmepumpe, Kleinspeicher, Wandspeicher, Standspeicher und/oder Kochendwassergerät, mit
- einer fluidführenden Leitung (9, 10, 11);
- einem sich über einen Heizleitungsabschnitt (9) erstreckenden Heizelement (12) zum Erwärmen des durch die Leitung (9, 10, 11) strömenden Fluids;
- einer Steuerungseinrichtung (3) zur Steuerung einer Heizleistung des Heizelements (12) zum Erwärmen des durch die Leitung strömenden Fluids; und
- einer mit der fluidführenden Leitung (9, 10, 11) verbundenen fluidführenden Baugruppe (16) nach einem der vorhergehenden Ansprüche.

14. Haustechnikgerät (100), insbesondere Durchlauferhitzer, nach Anspruch 13, wobei der Messsensor (21) ausgestaltet ist, um ein für die Leitfähigkeit des durch die fluidführende Leitung (9, 10, 11) strömenden Fluids charakteristisches Messsignal abzugreifen, und die Steuerungseinrichtung (3) vorzugsweise eingerichtet ist, um auf Basis der Leitfähigkeit die Heizleistung zu steuern.

15. Verwendung eines elektrisch leitenden Niederhalters (23) zum Niederhalten eines Messsensors (21) und Weiterleiten eines elektrischen Messsignals zwischen dem in eine fluidführenden Leitung (9, 10, 11) eines Haustechnikgeräts (100), insbesondere eines Durchlauferhitzers, eines Heißwassersystems, einer Trinkwasser-Wärmepumpe, eines Kleinspeichers, eines Wandspeichers, eines Standspeichers und/oder eines Kochendwassergeräts, zumindest teilweise hineinragenden Messsensor (21) und einer Steuerungseinrichtung (3) des Haustechnikgeräts (100), **dadurch gekennzeichnet, dass** der Niederhalter (23) einen Niederhalteabschnitt (23a) zum Niederhalten des Messsensors (21) und Ausbilden einer elektrisch leitenden Verbindung mit dem Messsensors (21) und einen mit dem Niederhalteabschnitt (23a) elektrisch leitend verbundenen Verbindungsabschnitt (23b) zum Schließen einer elektrischen Verbindung mit der Steuerungseinrichtung (3) aufweist.

## Claims

1. A fluid carrying assembly (16) for a building services appliance (100), in particular instantaneous water heater, hot water system, drinking water heat pump, small water heater, wall mounted cylinder, floor mounted cylinder and/or automatic water boiler, comprising:
- a fluid carrying component (15) comprising a component conduit portion (17) extending through the component (15) and including two connections, disposed in particular on opposite sides, for connecting to a respective fluid carrying conduit (9, 10, 11);
- a measuring sensor (21) at least partially projecting into the component conduit portion (17);
- a hold-down device (23) connected to the measuring sensor (21) in an electrically conducting manner for forwarding an electric measurement signal between the measuring sensor (21) and a control device (3) of the building services appliance (100),
**characterised in that**
the hold-down device (23) includes a first hold-down portion (23a) for holding down the measuring sensor (21) and forming an electrically conducting connection to the measuring sensor (21), and a first connecting portion (23b) connected to the hold-down portion (23a) in an electrically conducting manner for closing an electrical connection to the control device (3).

2. The fluid carrying assembly (16) according to claim 1, wherein the measuring sensor (21) is configured as a first electrode (22) and a second electrode (22') spaced apart from the first electrode (22), and optionally wherein the first hold-down portion (23a) includes openings for the two electrodes (22, 22') to pass through.

3. The fluid carrying assembly (16) according to claim 1 or 2, wherein the first hold-down portion (23a), in particular the openings, and a shell surface of the electrodes (22, 22') are adapted to one another such that a force-fit, form-fit and/or bonded connection is present between the hold-down device (23) and the measuring sensor (21).

4. The fluid carrying assembly (16) according to any one of the preceding claims, wherein the hold-down device (23) includes a fastening portion (23c) and/or the fluid carrying component (15) includes fasteners for fastening the hold-down device (23) to the fluid carrying component (15).

5. The fluid carrying assembly (16) according to any one of the preceding claims 2 to 4, wherein the hold-down device (23) is formed in two parts, and the first hold-down part (23') includes the first hold-down portion (23a) and the second hold-down part (23") includes a second hold-down portion (23a), wherein the first hold-down portion (23a) is configured for holding down and forming an electrically conducting connection to the first electrode (22'), and wherein the second hold-down portion (23a) is configured for holding down and forming an electrically conducting connection to the second electrode (22) and includes a second connecting portion (23b) connected to the second hold-down portion (23a) in an electrically conducting manner for closing a respective electrical connection to the control device (3).

6. The fluid carrying assembly (16) according to claim 5, wherein the two hold-down parts (23', 23") are designed to be identical and are in particular installed in a mirror-inverted manner.

7. The fluid carrying assembly (16) according to any one of the preceding claims 1 to 4, wherein the hold-down device (23) is formed in one part and includes a second hold-down portion, wherein the first hold-down portion (23a) is configured for holding down and forming an electrically conducting connection to the first electrode (22), and wherein the second hold-down portion (23a) is configured for holding down and forming an electrically conducting connection to the second electrode (22) and includes a second connecting portion (23b) connected to the second hold-down portion (23a) in an electrically conducting manner for closing a respective electrical connection to the control device (3).

8. The fluid carrying assembly (16) according to any one of the preceding claims, wherein the component (15) is manufactured from a non-conducting material.

9. The fluid carrying assembly (16) according to any one of the preceding claims, wherein the component (15) is formed as a flange (15) including a connection to a pipeline (10, 11), in particular a cold water pipeline and/or a hot water discharge pipeline, on one side and a connection to a heating conduit portion (9) on an opposite side.

10. The fluid carrying assembly (16) according to any one of the preceding claims, wherein the first and/or the second connecting portion (23b) is formed as an elongated flat piece, preferably for connection to a blade connector sleeve (24) or a PAST connector.

11. The fluid carrying assembly (16) according to any one of claims 1 to 9, wherein the first and/or the second connecting portion (23b) is formed as a strand connection.

12. The fluid carrying assembly (16) according to any one of the preceding claims 2 to 11, wherein the two electrodes (22, 22') are formed transverse to the flow channel of the component conduit portion (17).

13. A building services appliance (100), in particular instantaneous water heater, hot water system, drinking water heat pump, small water heater, wall mounted cylinder, floor mounted cylinder and/or automatic water boiler, comprising:
- a fluid carrying conduit (9, 10, 11);
- a heating element (12) extending across a heating conduit portion (9) for heating the fluid flowing through the conduit (9, 10, 11);
- a control device (3) for controlling a heating output of the heating element (12) for heating the fluid flowing thorough the conduit; and
- a fluid carrying assembly (16) according to any one of the preceding claims connected to the fluid carrying conduit (9, 10, 11).

14. The building services appliance (100), in particular instantaneous water heater, according to claim 13, wherein the measuring sensor (21) is configured to sense a measurement signal characteristic for the conductivity of the fluid flowing through the fluid carrying conduit (9, 10, 11), and the control device (3) is preferably arranged to control the heating output based on the conductivity.

15. The use of an electrically conducting hold-down device (23) for holding down a measuring sensor (21) and forwarding an electric measurement signal between a measuring sensor (21) at least partially projecting into a fluid carrying conduit (9, 10, 11) of a building services appliance (100), in particular an instantaneous water heater, a hot water system, a drinking water heat pump, a small water heater, a wall mounted cylinder, a floor mounted cylinder and/or an automatic water boiler and a control device (3) of the building services appliance (100),
**characterised in that** the hold-down device (23) includes a hold-down portion (23a) for holding down the measuring sensor (21) and forming an electrically conducting connection to the measuring sensor (21), and a first connecting portion (23b) connected to the hold-down portion (23a) in an electrically conducting manner for closing an electrical connection to the control device (3).

## Revendications

1. Module de guidage de fluide (16) pour un appareil domestique (100), notamment un chauffe-eau instantané, un système d'eau chaude, une pompe à chaleur d'eau sanitaire, un petit ballon d'eau chaude, un ballon d'eau chaude mural, un ballon d'eau chaude sur socle et/ou un appareil à eau bouillante instantanée, comprenant :
- un composant de guidage de fluide (15) comportant une section de conduite de composant (17) conduisant un fluide et s'étendant à travers le composant (15), laquelle section présente deux raccords disposés notamment sur des côtés opposés pour permettre un raccordement à une conduite de guidage de fluide (9, 10, 11) ;
- un capteur de mesure (21) pénétrant au moins partiellement dans la section de conduite de composant (17) ;
- un dispositif de retenue (23) relié de manière électriquement conductrice au capteur de mesure (21) pour transmettre un signal de mesure électrique entre le capteur de mesure (21) et un dispositif de commande (3) de l'appareil domestique (100),
**caractérisé en ce que**
le dispositif de retenue (23) présente une première section de retenue (23a) pour retenir le capteur de mesure (21) et établir une connexion électriquement conductrice avec le capteur de mesure (21), et une première section de connexion (23b) reliée de manière électriquement conductrice à la section de retenue (23a) pour fermer une connexion électrique avec le dispositif de commande (3).

2. Module de guidage de fluide (16) selon la revendication 1, dans lequel le capteur de mesure (21) est configuré sous la forme d'une première électrode (22) et d'une deuxième électrode (22') espacée de la première électrode (22), et dans lequel, facultativement, la première section de retenue (23a) présente des ouvertures pour le passage des deux électrodes (22, 22').

3. Module de guidage de fluide (16) selon la revendication 1 ou 2, dans lequel la première section de retenue (23a), notamment les ouvertures, et une surface d'enveloppe des électrodes (22, 22') sont adaptées l'une à l'autre de telle façon qu'il existe, entre le dispositif de retenue (23) et le capteur de mesure (21), une liaison par adhérence, par complémentarité de forme et/ou de matière.

4. Module de guidage de fluide (16) selon l'une des revendications précédentes, dans lequel le dispositif de retenue (23) comprend une section de fixation (23c) et/ou le composant de guidage de fluide (15) comprend des moyens de fixation pour fixer le dispositif de retenue (23) au composant de guidage de fluide (15).

5. Module de guidage de fluide (16) selon l'une des revendications précédentes 2 à 4, dans lequel le dispositif de retenue (23) est réalisé en deux parties et la première partie de retenue (23') présente la première section de retenue (23a) et la deuxième partie de retenue (23") présente une deuxième section de retenue (23a) ; la première section de retenue (23a) étant conçue pour retenir et établir une connexion électriquement conductrice avec la première électrode (22'), et la deuxième section de retenue (23a) étant conçue pour retenir et établir une connexion électriquement conductrice avec la deuxième électrode (22) et présentant une deuxième section de connexion (23b) reliée de manière électriquement conductrice à la deuxième section de retenue (23a) pour fermer une connexion électrique respective avec le dispositif de commande (3).

6. Module de guidage de fluide (16) selon la revendication 5, dans lequel les deux parties de retenue (23', 23") sont réalisées à l'identique et sont notamment montées de manière inversée l'une par rapport à l'autre.

7. Module de guidage de fluide (16) selon l'une des revendications précédentes 1 à 4, dans lequel le dispositif de retenue (23) est formé d'une seule pièce et comprend une deuxième section de retenue ; la première section de retenue (23a) étant configurée pour retenir et établir une connexion électriquement conductrice avec la première électrode (22), et la deuxième section de retenue (23a) étant configurée pour retenir et établir une connexion électriquement conductrice avec la deuxième électrode (22) et présentant une deuxième section de connexion (23b) reliée de manière électriquement conductrice à la deuxième section de retenue (23a) pour fermer une connexion électrique respective avec le dispositif de commande (3).

8. Module de guidage de fluide (16) selon l'une des revendications précédentes, dans lequel le composant (15) est fabriqué dans un matériau non conducteur.

9. Module de guidage de fluide (16) selon l'une des revendications précédentes, dans lequel le composant (15) est réalisé sous la forme d'une bride (15) qui présente, d'un côté, un raccord à une conduite (10, 11), notamment une conduite d'eau froide et/ou une conduite d'évacuation d'eau chaude, et, d'un côté opposé, un raccord à une section de conduite de chauffage (9).

10. Module de guidage de fluide (16) selon l'une des revendications précédentes, dans lequel la première et/ou la deuxième section de connexion (23b) se présente sous la forme d'une pièce plate allongée, de préférence pour une connexion avec une cosse plate (24) ou un connecteur à encliquetage.

11. Module de guidage de fluide (16) selon l'une des revendications 1 à 9, dans lequel la première et/ou la deuxième section de connexion (23b) sont réalisées sous la forme d'un raccord à torons.

12. Module de guidage de fluide (16) selon l'une des revendications précédentes 2 à 11, dans lequel les deux électrodes (22, 22') sont formées transversalement au canal d'écoulement de la section de conduite de composant (17).

13. Appareil domestique (100), en particulier un chauffe-eau instantané, un système d'eau chaude, une pompe à chaleur d'eau sanitaire, un petit ballon d'eau chaude, un ballon d'eau chaude mural, un ballon d'eau chaude sur socle et/ou un appareil à eau bouillante instantanée, comprenant :
- une conduite de guidage de fluide (9, 10, 11) ;
- un élément chauffant (12) s'étendant sur une section de conduite de chauffage (9) pour chauffer le fluide s'écoulant à travers la conduite (9, 10, 11) ;
- un dispositif de commande (3) pour commander la puissance de chauffe de l'élément chauffant (12) pour chauffer le fluide s'écoulant à travers la conduite ; et
- un module de guidage de fluide (16) selon l'une des revendications précédentes, relié à la conduite de guidage de fluide (9, 10, 11).

14. Appareil domestique (100), notamment chauffe-eau instantané, selon la revendication 13, dans lequel le capteur de mesure (21) est conçu pour prélever un signal de mesure caractéristique de la conductivité du fluide s'écoulant dans la conduite de guidage de fluide (9, 10, 11), et le dispositif de commande (3) est de préférence conçu pour commander la puissance de chauffe compte tenu de cette conductivité.

15. Utilisation d'un dispositif de retenue électriquement conducteur (23) pour la retenue d'un capteur de mesure (21) et la transmission d'un signal de mesure électrique entre le capteur de mesure (21), qui pénètre au moins partiellement dans une conduite de guidage de fluide (9, 10, 11) d'un dispositif domestique (100), notamment un chauffe-eau instantané, un système d'eau chaude, une pompe à chaleur d'eau sanitaire, un petit ballon d'eau chaude, un ballon d'eau chaude mural, un ballon d'eau chaude sur socle et/ou un appareil à eau bouillante instantanée, et un dispositif de commande (3) de l'appareil domestique (100),
**caractérisée en ce que** le dispositif de retenue (23) comprend une section de retenue (23a) pour retenir le capteur de mesure (21) et établir une connexion électriquement conductrice avec le capteur de mesure (21), et une section de connexion (23b) reliée de manière électriquement conductrice à la section de retenue (23a) pour fermer une connexion électrique avec le dispositif de commande (3).
